Europäisches Patentamt

European Patent Office

Office européen des brevets

(11) Numéro de publication : **0 054 998**
**B1**

(12) **FASCICULE DE BREVET EUROPÉEN**

(45) Date de publication du fascicule du brevet :
20.02.85

(21) Numéro de dépôt : **81201350.6**

(22) Date de dépôt : **11.12.81**

(51) Int. Cl.⁴ : **H 01 L 21/28, H 01 L 21/308,**
**H 01 L 29/80, H 01 L 29/60**

(54) **Procédé de fabrication de transistors à effet de champ à grille auto-alignée et transistors ainsi obtenus.**

(30) Priorité : **24.12.80 FR 8027423**

(43) Date de publication de la demande :
**30.06.82 Bulletin 82/26**

(45) Mention de la délivrance du brevet :
**20.02.85 Bulletin 85/08**

(84) Etats contractants désignés :
**DE FR GB NL**

(56) Documents cités :
**DE-A- 2 540 352**
**FR-A- 2 335 041**
**US-A- 4 194 285**
**PROCEEDINGS 1977 IEEE INTERNATIONAL MICRO-WAVE SYMPOSIUM New York, US J.C. VOKES et al.:**
**"A low noise FET Amplifier in coplanar waveguide"**
**pages 185-186**
**IEEE TRANSACTIONS ON ELECTRON DEVICES, vol. ED-27, juin 1980, New York, US KEITCHI OHATA et al.: "Super low-noise GaAs MESFET's with a deep recess structure", pages 1029-1034**

(73) Titulaire : **Laboratoires d'Electronique et de Physique Appliquée L.E.P.**
**3, Avenue Descartes**
**F-94450 Limeil-Brévannes (FR)**
**FR**
**N.V. Philips' Gloeilampenfabrieken**
**Groenewoudseweg 1**
**NL-5621 BA Eindhoven (NL)**
**DE GB NL**

(72) Inventeur : **Meignant, Didier**
**Société Civile S.P.I.D. 209 rue de l'Université**
**F-75007 Paris (FR)**

(74) Mandataire : **Gendraud, Pierre et al**
**Société Civile S.P.I.D. 209, rue de l'Université**
**F-75007 Paris (FR)**

Il est rappelé que : Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

## Description

L'invention concerne un procédé de fabrication de transistors à effet de champ, plus particulièrement à grille auto-alignée. L'invention concerne également les transistors FET (i. e. field-effect transistor) ainsi obtenus. Très généralement, l'invention ressort du domaine de l'industrie électronique, plus spécifiquement de l'élaboration de dispositifs semiconducteurs.

De l'art antérieur, il est connu de réaliser des transistors à effet de champ, à grille auto-alignée, et l'on citera pour mémoire un des premiers brevets, déposé aux Etats-Unis d'Amérique sur la technologie d'auto-alignement, le 10 Mars 1970, ayant pour titre : « Self-aligned gate field-effect transistor, and method of preparing », par Driver et d'autres, brevet délivré sous le numéro 3.678.573.

Ces procédés ont notamment permis de réaliser des transistors FET, à grilles microniques, à partir de l'adaptation d'une technologie commune telle que la photogravure.

Mais, alors que d'une part, la réduction de la longueur de grille trouvait sa limite naturelle dans la dimension minimale des ouvertures de masques utilisés et des effets de diffraction dus à la longueur d'onde du rayonnement employé, (cette dimension minimale est à l'heure actuelle aux environs de 0,3 micron), d'autre part, avec les techniques habituelles de formation des électrodes drain ou source du transistor FET, par exemple en un alliage or-germanium (Au-Ge = 80/20) de manière à obtenir un contact ohmique avec la couche semiconductrice recouverte, il se forme des micro-zones surdopées dans l'alliage, de telle sorte que la densité de courant n'est pas uniforme dans l'électrode, et que la tension de claquage est sensiblement peu élevée.

L'invention vise à pallier les susdits inconvénients, afin de réaliser des transistors FET dont les caractéristiques électriques sont améliorées, alors qu'en outre elle autorise la réalisation de transistors FET, à grille auto-alignée submicronique, sans qu'il soit nécessaire d'utiliser un masque submicronique.

Le procédé de réalisation selon la présente invention est remarquable en ce que :

a) l'on dépose, sur un corps de matériau semiconducteur, une première couche métallique, en un métal formant un contact redresseur avec le matériau semiconducteur ;

b) l'on recouvre ladite première couche métallique d'une laque photosensible ;

c) l'on expose ladite laque à un rayonnement sensibilisant, à travers un masque qui découvre une zone entière, définissant l'électrode de drain ;

d) l'on dissout la laque non sensibilisée, avec une solution appropriée ;

e) l'on effectue une sous-gravure de la laque sensibilisée, sur une distance typiquement inférieure au micron par gravure de ladite première couche métallique ;

f) l'on dépose une deuxième couche métallique, alignée sur le bord de la laque précédemment sous-gravée, en un métal ou alliage métallique, formant un contact ohmique avec le matériau semiconducteur, de manière à réaliser l'électrode de source ;

g) l'on enlève la laque sensibilisée, avec une solution appropriée ;

h) l'on grave le matériau semiconducteur, dans la zone non recouverte délimitée par les première et deuxième couches métalliques, sous la forme d'une cavité ;

i) l'on dépose une troisième couche métallique dans ladite cavité en un métal formant un contact redresseur avec le matériau semiconducteur, de manière à réaliser l'électrode de grille, par auto-alignement sur les bords supérieurs de ladite cavité.

Selon une réalisation de l'invention, dans le cas d'un matériau semiconducteur en arséniure de gallium, on choisit comme première couche métallique formant contact redresseur, une couche en un alliage tungstène-titane déposé par exemple par pulvérisation.

La description qui va suivre en regard des dessins annexés donnés à titre non limitatif, permettra de mieux comprendre comment l'invention se réalise et se poursuit, et de mieux en apprécier sa portée.

Les figures 1 à 6 représentent les diverses étapes du procédé de fabrication d'un transistor FET, selon la présente invention, en une vue en coupe.

La figure 7 est une vue de dessus de ce même transistor FET.

Les procédés de fabrication de transistors FET, selon l'art antérieur, par photogravure, ressortent de deux variantes :

— Une première variante, dite additive, développée vers 1964 ;

— une seconde variante, dite soustractive, développée vers 1970.

Selon la variante additive, telle que décrite et protégée par le brevet français 1 437 781, déposé le 21 Avril 1965, sous priorité des Pays-Bas du 21 Avril 1964, au nom de la Société dite N.V. PHILIPS' GLOEILAMPENFABRIEKEN, le procédé de fabrication consiste en ce que l'on dépose une première couche métallique, qui est ensuite recouverte d'un matériau de masquage, résistant au décapage, sous la forme d'un mince ruban, puis que la couche métallique est retirée aux endroits non masqués et gravée le long du masque et sous le masque, après quoi on applique la seconde couche métallique, en tirant parti de l'effet d'ombre du matériau du masque, de manière à obtenir les deux électrodes de drain et de source, alignées sur les bords du masque, puis que le masque est enlevé.

Ce procédé est dit additif, car le matériau semiconducteur n'est pas soumis à gravure, alors que les configurations d'électrode sont déposées de façon additive sur ledit matériau.

Selon la variante soustractive, telle que décrite et protégée par le brevet déposé aux Etats-Unis d'Amérique le 10 Mars 1970, et délivré sous le numéro 3.678.573, au nom de la Société cessionnaire WESTINGHOUSE ELECTRIC Corp., le procédé consiste à déposer une première couche métallique, à la recouvrir d'un matériau de masquage, qui laisse découvert un mince ruban, à décaper la couche métallique non recouverte et à graver le matériau semiconducteur sous la forme d'une cavité, puis à déposer une deuxième couche métallique, au moins dans ladite cavité sous la forme d'un mince ruban dont les bords sont en alignement avec les bords des couches métalliques délimitant ladite cavité, enfin à retirer le masque.

Ce procédé est dit soustractif, car le matériau semiconducteur est gravé sous la forme d'une cavité, alors qu'au moins une électrode (dans ce cas, l'électrode de grille) est déposée dans cette cavité.

Ces deux variantes présentent toutefois un inconvénient commun, celui de nécessiter la présence d'un masque, présentant une ouverture de l'ordre du, ou même inférieure, au micron.

Or, la réalisation de ces masques, à ouverture micronique ou submicronique s'avère difficile et coûteuse, et ce d'autant plus que l'ouverture est faible.

Le procédé selon la présente invention reprend certaines étapes élémentaires connues antérieurement, mais selon un agencement différent qui produit un effet technique certain, notamment en ce qu'il permet d'éviter la réalisation de masque submicronique.

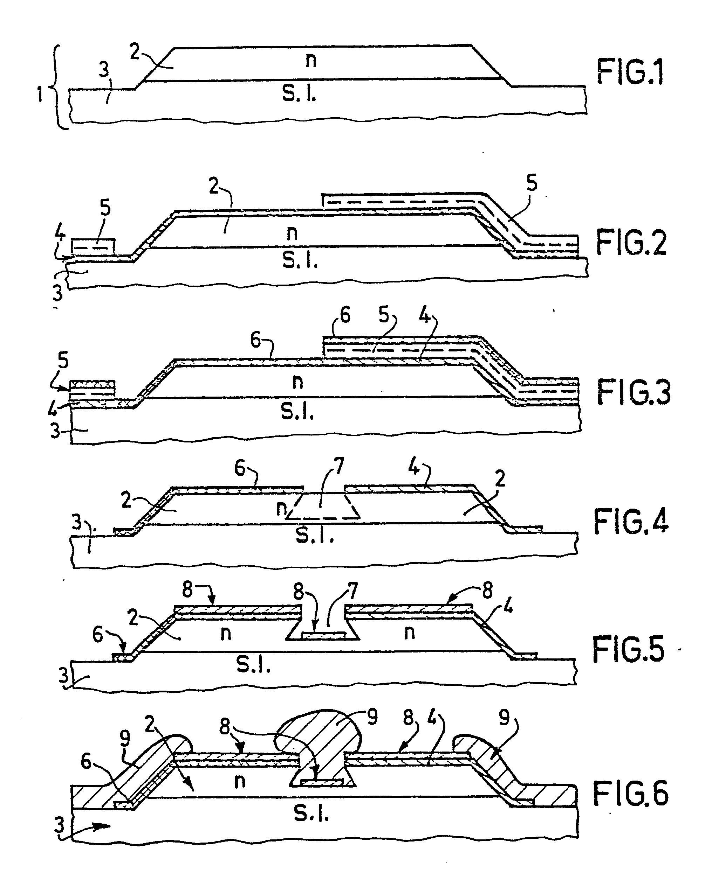

Le corps de matériau semiconducteur 1, tel que référencé à la figure 1, se présente sous la forme d'un plateau 2, ou « mésa », obtenu par photogravure d'une couche semiconductrice, par exemple de type de conductivité n, avec un dopage de l'ordre de $10^{17}$ atomes/cm$^3$ déposée par exemple par épitaxie en phase gazeuse, ou jet moléculaire, sur un substrat 3 typiquement semi-isolant, obtenu par exemple par dopage au chrome d'un matériau semiconducteur en arséniure de gallium.

Conformément à la présente invention, le procédé de fabrication de transistor à effet de champ consiste, dans une première étape, (figure 2) à déposer sur le plateau semiconducteur 2, une première couche métallique 4, en un métal formant un contact redresseur avec le matériau semiconducteur. L'épaisseur de cette couche 4, relativement mince, est par exemple de l'ordre de 2 000 Å.

Dans le cas d'un matériau semiconducteur en arséniure de gallium, choisi pour ses qualités électriques intrinsèques remarquables, cette couche métallique 4 peut être utilement réalisée en un alliage tungstène-titane (W/Ti = 90/10) ou en aluminium.

Sur cette couche métallique 4, il est alors déposé une couche de laque photosensible 5, qui est ensuite exposée aux rayons ultraviolets à travers un masque qui découvre une région entière définissant l'électrode de drain. La laque ainsi exposée et sensibilisée devient insoluble, c'est-à-dire qu'elle résiste à l'attaque par un acide, La laque non exposée est alors éliminée par une solution basique diluée (par exemple, une solution de soude diluée).

La couche métallique 4 est ensuite gravée (figure 3) aux endroits non recouverts de laque, au moyen d'un plasma ($CF_4 + O_2$) dans le cas de l'alliage tungstène-titane ou d'une solution de gravure appropriée, telle que de l'acide orthophosphorique dans le cas d'une couche d'aluminium. L'attaque est poursuivie jusqu'à ce qu'il apparaisse une gravure d'environ 0,3 μm de la couche métallique 4, sous la laque protectrice 5. Il est alors déposé par évaporation une deuxième couche métallique 6, en un métal ou alliage formant un contact ohmique avec le matériau semiconducteur recouvert. Par exemple, dans le cas d'un matériau semiconducteur en arséniure de gallium (GaAs), l'alliage or-germanium déposé par évaporation (Au-Ge = 80/20) convient parfaitement pour ce contact ohmique. Cette couche métallique 6 est en fait séparée en deux parties distinctes, une première partie en contact avec le matériau semi conducteur, dans la région destinée à devenir l'électrode de source, et dont un bord est aligné sur le bord de la couche de laque précédemment sous-gravée, et une deuxième partie déposée sur la laque restante.

Cette laque restante, sensibilisée aux rayons ultraviolets, est ensuite retirée (figure 4) au moyen d'un solvant approprié. Ainsi, dans le cas d'une laque positive du type « Shipley » (par exemple, la laque référencée AZ 1370) un solvant approprié est l'acétone. Avec le départ de la laque sensibilisée, la couche métallique 6 qui la recouvre est également retirée (procédé dit de « lift-off » en anglo-saxon).

La couche semiconductrice est alors gravée, dans la zone non recouverte, délimitée par les première et deuxième couches métalliques 4 et 6, séparées par un interstice de longueur constante (environ 0,5 μm), sur une largeur qui peut atteindre une centaine de microns. Les parties externes au transistor peuvent être protégées durant cette opération par un masque en laque photosensible supplémentaire.

Dans le cas du choix de l'arséniure de gallium, en tant que matériau semiconducteur, une solution de gravure appropriée peut être par exemple de l'acide citrique, et l'on obtient ainsi une cavité 7, telle que représentée à la figure 5.

Enfin, on dépose, par exemple par évaporation, une troisième couche métallique 8 dans ladite cavité 7 (figure 5) en un métal formant un contact redresseur avec le matériau semiconducteur 1, de telle sorte qu'il se forme dans ladite cavité 7 un mince ruban dont les bords sont en alignement avec les bords des première et seconde couches métalliques 4 et 6, du fait que le dépôt d'un corps par voie d'évaporation s'effectue toujours sensiblement en ligne droite, entre la zone d'évaporation d'évaporation et la zone de dépôt.

Un tel métal 8 est choisi parmi les métaux formant un contact redresseur avec le matériau semiconducteur 1, et dans le cas du choix de l'arséniure de gallium à titre de matériau semiconducteur, on citera, sans que cette liste soit limitative, comme métaux ou alliages, l'aluminium, le titane-tungstène suivis d'une couche d'or (Ti/W : 90/10), ou même des couches successives, préférentiellement le titane, platine, or, mais encore, le chrome, platine, or.

D'autres matériaux convenables pourront être aisément choisis par l'homme de l'art sans pour cela faire œuvre d'esprit, et l'on citera pour mémoire l'ouvrage de SZE ayant pour titre : « Physics of semiconductor devices » New-York, John Wiley (1969) qui traite de ce choix.

Des revêtements de protection peuvent être également rajoutés, ainsi la figure 6 montre une vue en coupe du dispositif final, revêtu d'un verre de silice 9, que l'on peut déposer par exemple par pulvérisation, évaporation ou décomposition de silane (CVD).

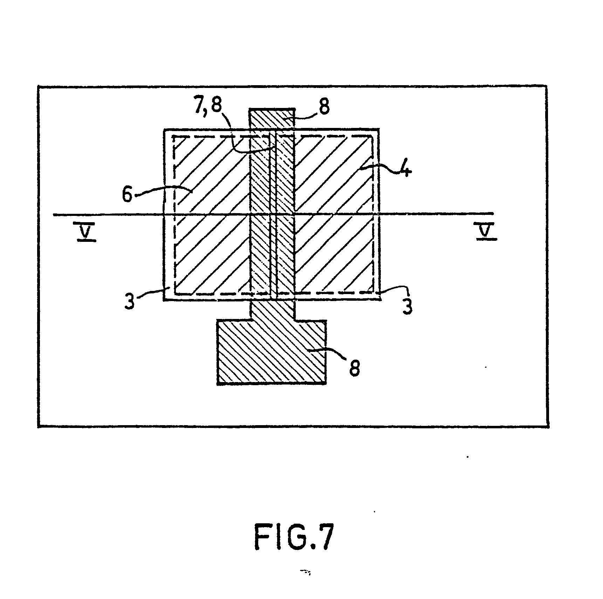

La figure 7 est une vue plane du même dispositif achevé où les éléments identiques sont représentés par la même référence, alors que l'axe V-V représente l'axe de coupe pour la précédente figure 5.

Il est bien évident pour l'homme de l'art que de nombreuses variantes peuvent être imaginées sans pour cela sortir du cadre de la présente invention, tel que défini par les revendications ci-après annexées, ainsi pour le choix du matériau semiconducteur, ou des différentes couches métalliques déposées.

## Revendications

1. Procédé de fabrication de transistors à effet de champ, à grille auto-alignée submicronique, caractérisé en ce que :

a) l'on dépose, sur un corps de matériau semiconducteur (1), une première couche métallique (4), en un métal formant un contact redresseur avec le matériau semiconducteur ;

b) l'on recouvre ladite première couche métallique (4) d'une laque photosensible (5) ;

c) l'on expose ladite laque à un rayonnement sensibilisant, à travers un masque qui découvre une zone entière, définissant l'électrode de drain ;

d) l'on dissout la laque non sensibilisée, avec une solution appropriée ;

e) l'on effectue une sous-gravure de la laque sensibilisée, sur une distance typiquement inférieure au micron par gravure de ladite première couche métallique (4) ;

f) l'on dépose une deuxième couche métallique (6), alignée sur le bord de la laque précédemment sous-gravée, en un métal ou alliage métallique, formant un contact ohmique avec le matériau semiconducteur, de manière à réaliser l'électrode de source ;

g) l'on enlève la laque sensibilisée (5), avec une solution appropriée ;

h) l'on grave le matériau semiconducteur, dans la zone non recouverte délimitée par les première et deuxième couches métalliques, sous la forme d'une cavité (7) ;

i) l'on dépose une troisième couche métallique (8), dans ladite cavité (7), en un métal formant un contact redresseur avec le matériau semiconducteur, de manière à réaliser l'électrode de grille, par auto-alignement sur les bords supérieurs de ladite cavité.

2. Procédé de fabrication de transistors à effet de champ à grille auto-alignée submicronique, selon la revendication 1, caractérisé en ce que le matériau semiconducteur est de l'arséniure de gallium.

3. Procédé de fabrication de transistors à effet de champ, à grille auto-alignée submicronique, selon la revendication 1 ou 2, caractérisé en ce que la première couche métallique (4) est en un alliage tungstène-titane.

4. Procédé de fabrication de transistors à effet de champ, à grille auto-alignée submicronique, selon l'une des revendications 1 à 3, caractérisé en ce que la deuxième couche métallique (6) est en un alliage or-germanium.

5. Procédé de fabrication de transistors à effet de champ, à grille auto-alignée submicronique, selon l'une des revendications 1 à 4, caractérisé en ce que la troisième couche métallique (8) est réalisée sous la forme de plusieurs sous-couches métalliques, respectivement dans l'ordre de dépôt, de titane, de platine et d'or.

6. Transistors à effet de champ, à grille auto-alignée submicronique, obtenus par la mise en œuvre du procédé selon l'une des revendications 1 à 5.

## Claims

1. A method of manufacturing field effect transistors having a submicron self-aligned gate, characterized in that :

a) there is deposited on a body of semiconductor material (1) a first metal layer (4) of a metal forming a rectifying contact with the semiconductor material ;

b) the said first metal layer (4) is covered by a photosensitive lacquer (5) ;

c) the said lacquer is subjected to a sensitizing radiation through a mask which covers a whole zone defining the drain electrode ;

d) the non-sensitized lacquer is dissolved by a suitable solution ;

e) the sensitized lacquer is underetched over a distance typically less than a micron by etching the said first metal layer (4) ;

f) a second metal layer (6) is deposited aligned with the edge of the lacquer previously underetched which layer consists of a metal or a metal alloy forming an ohmic contact with the semiconductor material in order to obtain the source electrode ;

g) the sensitized lacquer (5) is removed by a suitable solution ;

h) the semiconductor material is etched in the uncovered zone limited by the first and second metal layers in the form of a cavity (7) ;

i) a third metal layer (8) is deposited in the said cavity (7), which layer consists of a metal forming a rectifying contact with the semiconductor material in order to obtain the gate electrode by self-alignment with the upper edges of the said cavity.

2. A method of manufacturing field effect transistors having a submicron self-aligned gate as claimed in Claim 1, characterized in that the semiconductor material is gallium arsenide.

3. A method of manufacturing field effect transistors having a submicron self-aligned gate as claimed in Claim 1 or 2, characterized in that the first metal layer (4) consists of a tungstens-titanium alloy.

4. A method of manufacturing field effect transistors having a submicron self-aligned gate as claimed in any one of Claims 1 to 3, characterized in that the second metal layer (6) consists of a gold-germanium alloy.

5. A method of manufacturing field effect transistors having a submicron self-aligned gate as claimed in any one of Claims 1 to 4, characterized in that the third metal layer (8) is in the form of several deposited metal sublayers successively consisting of titanium, platinum and gold, respectively.

6. Field effect transistors having a submicron self-aligned gate obtained by the use of the method claimed in any one of Claims 1 to 5.

**Ansprüche**

1. Verfahren zum Herstellen von Feldeffekttransistoren mit einem selbstorientierten Gitter in dem Subminiaturbereich, dadurch gekennzeichnet, dass :

a) eine erste Metallschicht (4) aus einem Metall, das mit einem Halbleitermaterial einen Gleichrichterkontakt bildet, auf einem Körper aus Halbleitermaterial (1) niedergeschlagen wird ;

b) die genannte erste Metallschicht (4) mit einem lichtempfindlichen Lack (5) bedeckt wird ;

c) der genannte Lack über eine Maske, die eine Zone freigibt, die die Drain-Elektrode bestimmt, einer sensibilisierenden Strahlung ausgesetzt wird ;

d) der nicht sensibilisierte Lack mit einem geeigneten Lösungsmittel gelöst wird ;

e) eine Unterätzung des sensibilierten Lackes über einen Abstand, der wesentlich kleiner ist als ein Mikron, durch Gravieren der genannten ersten Metallschicht (4) durchgeführt wird ;

f) eine zweite Metallschicht (6) orientiert auf den Rand des vorher untergeätzten Lackes, aus einem Metall oder einer Metallegierung, das bzw. die mit dem Halbleitermaterial einen ohmschen Kontakt bildet, niedergeschlagen wird um auf diese Weise die Source-Elektrode zu verwirklichen ;

g) der sensibilierte Lack (5) mit einem geeigneten Lösungsmittel entfernt wird ;

h) das Halbleitermaterial in der nicht bedeckten Zone, die durch die ersten und zweiten Metallschichten begrenzt ist, in Form eines Hohlraumes (7) geätzt wird ;

i) eine dritte Metallschicht (8) aus einem Metall, das mit dem Halbleitermaterial einen Gleichrichterkontakt bildet, in dem genannten Hohlraum (7) gebildet wird um die Gitter-Elektrode zu verwirklichen, die gegenüber den oberen Kanten des genannten Hohlraumes selbstorientiert ist.

2. Verfahren zum Herstellen von Feldeffekttransistoren mit einem selbstorientierten Gitter in dem Subminiaturbereich nach Anspruch 1, dadurch gekennzeichnet, dass das Halbleitermaterial Galliumarsenid ist.

3. Verfahren zum Herstellen von Feldeffekttransistoren mit einem selbstorientierten Gitter in dem Subminiaturbereich nach Anspruch 1 oder 2, dadurch gekennzeichnet, dass die erste Metallschicht (4) eine Wolfram-Titan-Legierung ist.

4. Verfahren zum Herstellen von Feldeffekttransistoren mit einem selbstorientierten Gitter in dem Subminiaturbereich nach einem der Ansprüche 1 bis 3, dadurch gekennzeichnet, dass die zweite Metallschicht (6) eine Gold-Germanium-Legierung ist.

5. Verfahren zum Herstellen von Feldeffekttransistoren mit einem selbstorientierten Gitter in dem Subminiaturbereich nach einem der Ansprüche 1 bis 4, dadurch gekennzeichnet, dass die dritte Metallschicht (8) in Form mehrerer metallischer Teilschichten in der Reihenfolge des Niederschlags, Titan, Platin beziehungsweise Gold verwirklicht ist.

6. Feldeffekttransistoren mit einem selbstorientierten Gitter in dem Subminiaturbereich, dadurch erhalten, dass das Verfahren durchgeführt wird nach einem der Ansprüche 1 bis 5.

FIG.1

FIG.2

FIG.3

FIG.4

FIG.5

FIG.6

FIG.7